Europäisches Patentamt

European Patent Office

Office européen des brevets

(11) Veröffentlichungsnummer: **0 222 305**

**A1**

(12) **EUROPÄISCHE PATENTANMELDUNG**

(21) Anmeldenummer: 86115274.2

(22) Anmeldetag: 04.11.86

(51) Int. Cl.⁴ **H02H 9/04** , H01L 27/06 , H01L 29/74

(30) Priorität: 04.11.85 DE 3539108

(43) Veröffentlichungstag der Anmeldung:
20.05.87 Patentblatt 87/21

(84) Benannte Vertragsstaaten:
**DE FR GB IT SE**

(71) Anmelder: **Siemens Aktiengesellschaft Berlin
und München**
**Wittelsbacherplatz 2**
**D-8000 München 2(DE)**

(72) Erfinder: **Hertrich, Helmut, Dipl.-Phys.**
**Hirtenanger 1**
**D-8049 Weng(DE)**
Erfinder: **Kirschner, Fritz, Dipl.-Ing.**
**Siedlerstrasse 47 A**
**D-8044 Lohhof(DE)**
Erfinder: **Tihanyi, Jenö, Dr.**
**Windeckstrasse 1d**
**D-8000 München 70(DE)**

(54) Integrierte Schaltungsanordnung zum Schutz von Teilnehmerleitungen gegen Überspannungen.

(57) Teilnehmerleitungen werden gegen durch Blitzeinwirkung oder induktiv von Hochspannungsleitungen erzeugte Überspannungen durch einen feldgesteuerten Thyristor (1) geschützt, der zwischen einer Ader der Teilnehmerleitung und Masse liegt. Der Thyristor wird über eine integrierte Zenerdiodenkette (3) gezündet. Die Zenerdiodenkette weist Kurzschlußbrücken (4) auf, die nach Maßgabe einer vorgegebenen Durchbruchsspannung unterbrochen werden. Damit ist die Schutzspannung auf einfache Weise unabhängig von den Eigenschaften des für den Thyristor (1) verwendeten Halbleitermaterials einstellbar.

FIG 1

EP 0 222 305 A1

# Integrierte Schaltungsanordnung zum Schutz von Teilnehmerleitungen gegen Überspannungen

Die Erfindung bezieht sich auf eine integrierte Schaltungsanordnung zum Schutz von Teilnehmerleitungen gegen Überspannungen.

Zum Schutz von Teilnehmerleitungen gegen beispielsweise durch Blitzschlag oder Induktion von elektrischen Bahnen erzeugte Überspannungen werden Schutzbauelemente verwendet, die zwischen einer der Teilnehmerleitungen und Masse angeschlossen werden. Diese Schutzbauelemente sind so aufgebaut, daß sie unterhalb einer für die Vermittlungseinrichtung gefährlichen Überspannung durchbrechen und den durch die Überspannung hervorgerufenen Strom nach Masse abfließen lassen.

Als Schutzbauelemente wurden bereits Vierschichtdioden vorgeschlagen, die oberhalb einer vorgegebenen Spannung, auch Schutzspannung genannt, durchzünden (man vergleiche DE-OS 34 28 067). Von den Betreibern der Kommunikationsnetze werden aber verschiedene Schutzspannungen von einigen 10 V bis einigen 100 V gefordert. Das bedeutet, daß für jede Schutzspannung eine für eine bestimmte Durchbruchsspannung konzipierte Vierschichtdiode entwickelt werden muß. Da die Durchbruchsspannung solcher Vierschichtdioden neben von der Dicke der Mittelzone maßgeblich von deren spezifischen Widerstand abhängt, muß stets Halbleitermaterial mit verschiedenen Grunddotierungen in Vorrat gehalten werden. Da der spezifische Widerstand des Halbleitermaterials sogar innerhalb einer Herstellungscharge erheblich schwanken kann, heißt dies, daß die Schutzbauelemente praktisch Stück für Stück nach ihrer Durchbruchsspannung ausgesucht werden müssen.

Der Erfindung liegt die Aufgabe zugrunde, eine integrierte Schaltungsanordnung zum Schutz von Teilnehmerleitungen gegen Überspannungen zu - schaffen, deren Schutzspannung vom spezifischen Widerstand des Halbleitermaterials unabhängig ist und in weiten Grenzen geändert werden kann.

Diese Aufgabe wird gelöst
durch einen feldsteuerbaren Thyristor mit einer gegen den Halbleiterkörper isolierten Gateelektrode,
durch einen zwischen Katodenelektrode und Gateelektrode angeschlossenen Widerstand,
durch eine zwischen Gateelektrode und Anodenelektrode angeschlossene Reihenschaltung von Zenerdioden, durch jeweils zwischen Anode und Katode mindestens eines Teils der Zenerdioden angeordnete Kurzschlußbrücken, von denen mindestens ein Teil entsprechend einer vorgegebenen Durchbruchsspannung der Reihenschaltung unterbrochen ist,
und durch eine Durchbruchsspannung des Thyristors, die größer als die Durchbruchsspannung der Reihenschaltung sämtlicher Zenerdioden ist.

Weiterbildungen der Erfindung sind Gegenstand der Unteransprüche.

Die Erfindung wird anhand zweier Ausführungsbeispiele in Verbindung mit den Fig. 1 bis 5 näher erläutert. Es zeigen:

Fig. 1 das Schaltbild der erfindungsgemäßen Anordnung,

Fig. 2 einen Schnitt durch eine integrierte Schaltungsanordnung nach Fig. 1,

Fig. 3 die Aufsicht auf ein Detail einer integrierten Schaltungsanordnung und

Fig. 4 und 5 die Aufsicht auf zwei integrierte Schaltungsanordnungen mit unterschiedlicher Durchbruchsspannung.

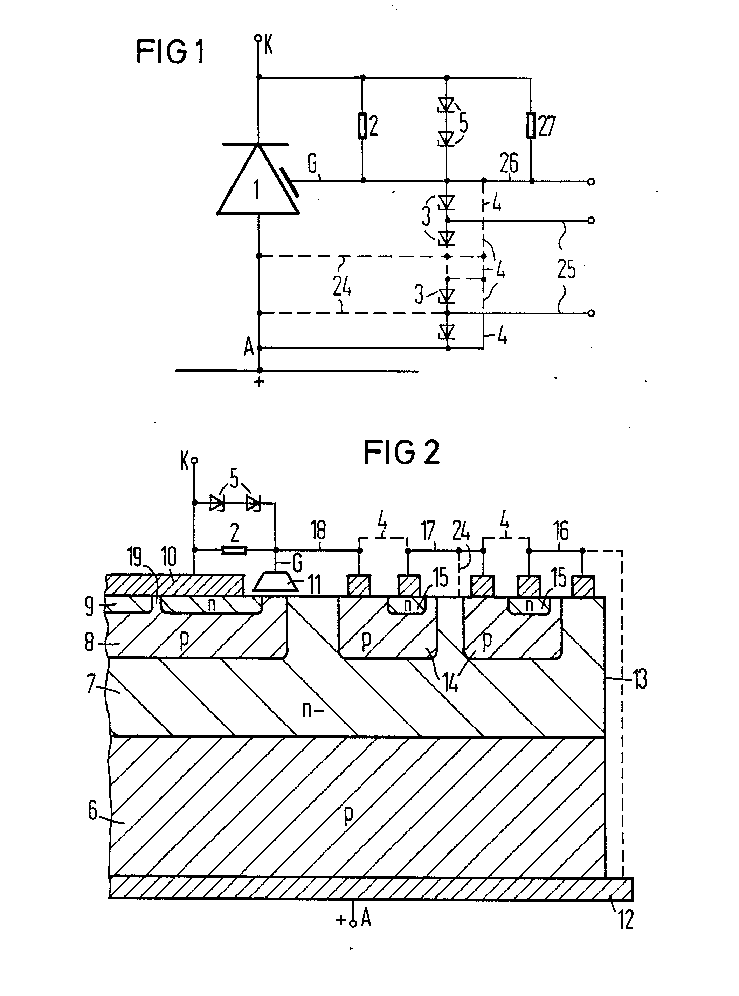

Die Schaltungsanordnung nach Fig. 1 enthält einen feldgesteuerten Thyristor 1, der z. B. zwischen einer Teilnehmerleitung und z. B. Masse liegt. Soll die Anordnung gegen Überspannungen beider Polaritäten schützen, wird der Thyristor zwischen die Gleichstromklemmen einer Gleichrichterbrücke geschaltet, deren Wechselspannungs- -klemmen an die beiden Adern der Leitung angeschlossen sind. Zwischen seinem Katodenanschluß K und dem Gateanschluß G liegt ein Widerstand 2. Zwischen dem Gateanschluß G und dem Anodenanschluß A liegt eine Reihenschaltung aus Zenerdioden 3. Jede dieser Zenerdioden ist mit einer Kurzschlußbrücke 4 versehen, die zwischen Anodenanschluß und Katodenanschluß der Zenerdiode liegt. Mindestens eine der Kurzschlußbrücken ist unterbrochen, so daß zwischen dem Gateanschluß und dem Anodenanschluß des Thyristors 1 mindestens die Zenerspannung eirfer Zenerdiode abfällt. Im Ausführungsbeispiel seien alle Kurzschlußbrücken 4 bis auf die der untersten Zenerdiode unterbrochen. Die zwischen Gate und Anode liegende Spannung bestimmt sich dann zu - (n-1) $U_z$, wenn n die Anzahl der Zenerdioden 3 ist.

Um die Gate-Source-Kapazität des Thyristors 1 zu schützen, ist est vorteilhaft, dem Widerstand eine Zenerdiode 5 oder die Reihenschaltung aus mehreren Zenerdioden parallel zu schalten.

Tritt zwischen Anode und Katode des Thyristors 1 eine Überspannung auf, so bricht die aus den Zenerdioden 3 gebildete Reihenschaltung bei einer Spannung durch, die der Summe der Zenerspannungen der nicht überbrückten Zenerdioden entspricht. Dann fließt ein Strom durch den Widerstand 2 und lädt die Gate-Source-Kapazität des Thyristors 1 auf. Der Thyristor wird damit gezündet und schließt die Teilnehmerleitung gegen Masse kurz. Nach Aufhören der Überspannung entlädt sich die Gate-Source-Kapazität des Thyristors 1 und der Thyristor sperrt, wenn der Störstrom den Haltestrom unterschreitet. Damit ist die Teilnehmerleitung wieder betriebsfähig.

Die integrierte Schaltungsanordnung nach Fig. 2 weist ein Substrat 6 von einer gegebenen Dotierungshöhe des ersten Leitungstyps auf. Es kann beispielsweise stark p-dotiert sein. Das Substrat 6 dient als Anodenzone des Thyristors. Auf dem Substrat 6 ist eine schwächer dotierte Zone 7 des entgegengesetzten Leitungstyps aufgebracht. Im Ausführungsbeispiel ist sie n-leitend. Sie ist die anodenseitige Basiszone des Thyristors. In die Mittelzone 7 ist eine Zone 8 des ersten Leitungstyps planar eingebettet. Sie ist stärker dotiert als die Zone 7 und bildet die katodenseitige Basiszone des Thyristors. Diese Basiszone ist auch die Gatezone des integrierten MOSFET. In die Basiszone 8 ist eine Zone 9 des zweiten Leitungstyps planar eingebettet. Sie ist höher als die Zone 8 dotiert und dient als Katodenzone. Sie kann auch als Sourcezone des MOSFET betrachtet werden.

Die Katodenzone 9 ist mit einer Katodenelektrode 10 versehen. Zwischen Gatezone und Katodenzone sind Nebenschlüsse 19 angeordnet, von denen hier nur einer dargestellt ist. Diese Nebenschlüsse dienen neben der Verbesserung der du/dt-Festigkeit dazu, den Haltestrom des Thyristors zu erhöhen, so daß er im normalen Kommunikationsbetrieb gesperrt ist.

Die Zonen 6, 7, 8 und 9 bilden den Thyristor. Dieser ist vorzugsweise im Zentrum des Halbleiterkörpers angeordnet, um eine optimale Wärmeabfuhr zu erreichen. Die Gatezone tritt zwischen der Katodenzone 9 und dem Rand 13 des Halbleiterkörpers an die katodenseitige Oberfläche des Halbleiterkörpers. Sie ist dort mit einer Gateelektrode 11 überdeckt, die gegen die Basiszone 8 durch eine nicht dargestellte Isolierschicht isoliert ist. Die Gateelektrode 11 ist über die Zenerdiode 5 bzw. die Reihenschaltung aus mehreren Zenerdioden 5 und den parallelgeschalteten Widerstand 2 mit der Katodenelektrode 10 verbunden.

Die Zenerdioden sind zweckmäßigerweise zwischen dem Thyristor und dem Rand 13 des Halbleiterkörpers angeordnet. Sie bestehen aus Anodenzonen 14, die planar in die anodenseitige Basiszone 7 eingebettet sind. In die Anodenzonen 14 ist je eine Katodenzone 15 planar eingebettet. Die Zonen 14 und 15 entsprechen in ihrer Tiefe und Dotierung zweckmäßigerweise den Zonen 8 bzw. 9 und können daher gleichzeitig mit diesen hergestellt werden.

Die Katodenzone 15 der dem Rand benachbarten Zenerdiode, im folgenden kurz erste Zenerdiode genannt, ist über einen Leiter 16 mit der Mittelzone 7 verbunden. Ist der pn-Übergang zwischen den Zonen 6 und 7 in Durchlaßrichtung vorgespannt, so liegt an der Katodenzone 15 der ersten Zenerdiode Anodenpotential abzüglich der Durchlaßspannung des pn-Übergangs zwischen den Zonen 6 und 7 an. Die Katodenzone 15 der ersten Zenerdiode könnte aber auch, wie gestrichelt dargestellt, direkt mit einer Anodenelektrode 12 verbunden sein.

Die Anodenzone 14 der ersten Zenerdiode ist über eine Leitung 17 mit der Katodenzone einer zweiten Zenerdiode verbunden. Die Anodenzone der zweiten Zenerdiode ist über eine Leitung 18 mit der Gateelektrode 11 verbunden. Zwischen der Anodenzone und der Katodenzone der Zenerdioden liegen die Kurzschlußbrücken 4, die hier beide unterbrochen sind. Im Fall des Auftretens einer Überspannung zwischen Anode und Katode liegt dann an der Gateelektrode 11 die Summe der Zenerspannungen beider Zener dioden zuzüglich der erwähnten Durchlaßspannung an. Bei dieser Spannung wird dann die Gate-Source-Kapazität des feldgesteuerten Thyristors aufgeladen und der Thyristor wird gezündet.

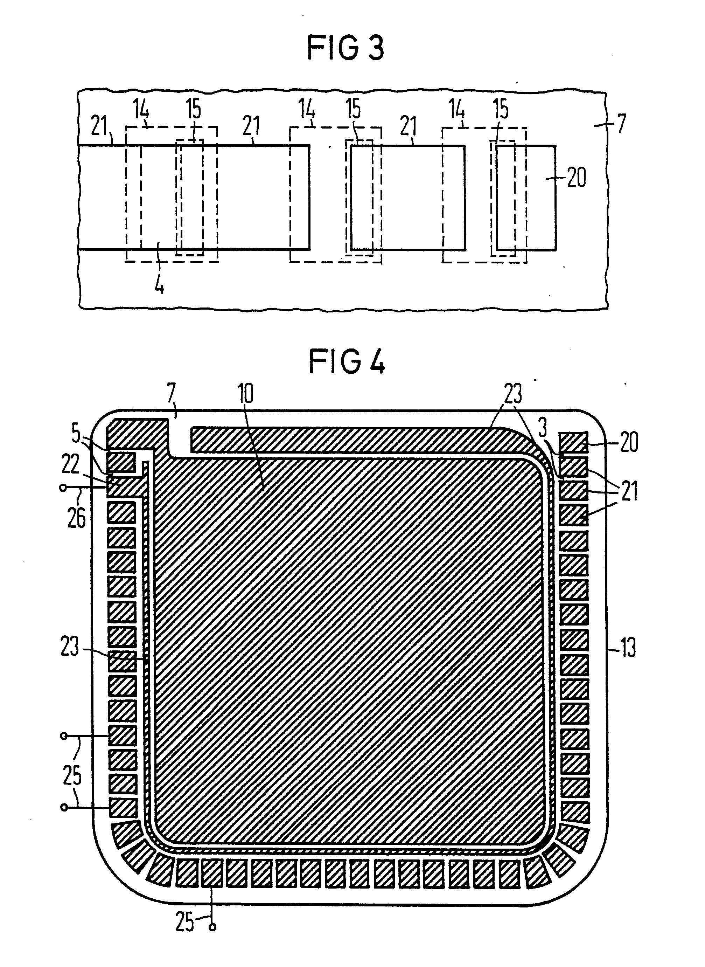

Die Verbindungsleitungen 16, 17 und 18 sowie die Kurzschlußbrücken 4 werden in der integrierten Schaltungsanordnung durch Metallschichten realisiert. In Fig. 3 ist eine teilweise Aufsicht auf ein Detail einer integrierten Schaltungsanordnung mit drei Zenerdioden dargestellt. Die Katodenzone 15 der ganz rechts liegenden ersten Zenerdiode ist über eine Leiterbahn 20 mit der Mittelzone 7 verbunden. Diese Leiterbahn 7 ist gegen die Anodenzone 15 durch eine nicht dargestellte Isolationsschicht elektrisch isoliert. Die Anodenzone 14 der ersten Zenerdiode ist über eine Leiterbahn 21 mit der Katodenzone der zweiten Zenerdiode verbunden. Die Leiterbahn ist gegen die Anodenzone 14 und die Mittelzone 7 elektrisch isoliert. Die Anodenzone der zweiten Zenerdiode ist über eine Leiterbahn 22 mit der Katodenzone der dritten Zenerdiode 15 verbunden, sie ist ebenfalls gegen die Mittelzone 7 elektrisch isoliert. Die Anodenzone der zweiten Zenerdiode ist über eine Leiterbahn 22 mit der Katodenzone der dritten Zenerdiode elektrisch verbunden. Die Anodenzone der dritten Zenerdiode ist über eine Leiterbahn 23 kontaktiert, die zur Katodenzone der nächsten Zenerdiode führt. Die Anodenzone 14 der dritten Zenerdiode ist mit der Katodenzone 15 durch eine Kurzschlußbrücke 4 kurzgeschlossen, die ebenfalls als Leiterbahn ausgebildet ist. Die dritte Zenerdiode ist daher nicht in Funktion.

In Fig. 4 ist die Aufsicht auf ein erstes Ausführungsbeispiel der integrierten Schaltungsanordnung dargestellt. Der besseren Übersichtlichkeit halber ist hier lediglich der Halbleiterkörper mit den aufgebrachten Metallschichten 10 dargestellt. Zentral im Halbleiterkörper ist der Thyristor angeordnet; er nimmt mit der Katodenelektrode 10 den größten Teil der Fläche des Halbleiterkörpers ein. Die Katodenzone bzw. Katodenelektrode 10 des Thyristors ist von der Gateelektrode umgeben, die mit einer Metallschicht 23 bedeckt ist. Zwischen der Gateelektrode und dem Rand 13 des Halbleiterkörpers sind die Zenerdioden 3 und 5 angeordnet. Sie liegen zweckmäßigerweise in einer Reihe einzeln hintereinander, um dem Thyristor die größtmögliche Fläche im Zentrum des Halbleiterkörpers zur Verfügung zu stellen. Die Metallschicht 23 ist über eine Leiterbahn 22 mit der Katodenzone einer Zenerdiode 5 bzw. der Anodenzone der letzten von mehreren in Reihe geschalteten Zenerdioden 3 verbunden.

Im Ausführungsbeispiel nach Fig. 4 sind sämtliche Kurzschlußbrücken unterbrochen, so daß sich die Durchbruchsspannung des Thyristors als Summe der Zenerspannungen sämtlicher auf dem Halbleiterkörper integrierten Zenerdioden 3 ergibt.

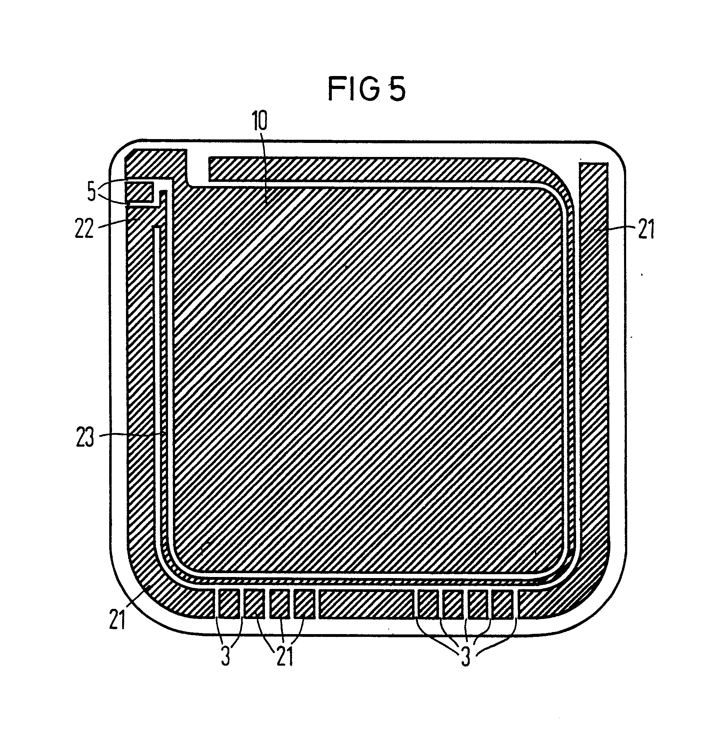

Im Ausführungsbeispiel nach Fig. 5 sind insgesamt zehn Kurzschlußbrücken unterbrochen. Die Durchbruchsspannung ist damit $10 \times U_z$ gleich z. B. 60 V. Eine Zenerspannung von 6 V empfiehlt sich, weil bis zu dieser Spannung der Zenereffekt alleine für den Durchbruch verantwortlich ist. Dieser ist praktisch nicht temperaturabhängig.

Die Schutzbauelemente werden zweckmäßigerweise derart hergestellt, daß zunächst sämtliche Zenerdioden durch die Kurzschlußbrücken kurzgeschlossen sind. Die Kurzschlußbrücken werden dann je nach gewünschter Schutzspannung entfernt. Damit läßt sich mit einem Bauelement ein großer Bereich der gewünschten Schutzspannungen abdecken. Die Materialeigenschaften des Thyristors spielen hierbei keine Rolle, solange die Durchbruchsspannung des Thyristors so groß gewählt ist, daß sie größer ist als die Summe aller im Halbleiterkörper integrierten, zwischen Gateelektrode und Anodenzone liegenden Zenerdioden 3. Statt einer Unterbrechung der Kurzschlußbrücken 4 können auch Kurzschlußbrücken 24 dazu verwendet werden, eine der Zenerdioden 3 direkt mit der Basiszone 7 (Fig. 2) oder mit der Anodenzone 6 (Fig. 1) zu verbinden. Dann ergibt sich die Durchbruchsspannung aus der Summe der Zenerspannungen der zwischen Gateelektrode 11 under der Kurzschlußbrücke 24 liegenden Zenerdioden 3.

Es ist auch möglich, die Verbindungsleitungen zwischen den Zenerdioden mit Anschlußleitern 25 - (Fig. 1) zu versehen, die durch das Gehäuse der Anordnung nach außen geführt sind. Damit kann die Schutzspannung vom Betreiber des Kommunikationsnetzes selbst eingestellt werden. Die Kombination von fest eingestellten Kurzschlüssen und wählbar einstellbaren Kurzschlüssen ist auch möglich.

Es ist auch denkbar, eine Schutzspannung dadurch fest einzustellen daß die Katodenzone 15 einer der Zenerdioden 3 z. B. durch Laserstrahl unter Zerstörung der entsprechenden Anodenzone 14 direkt leitend mit der Basiszone 7 verbunden wird.

Wird neben dem Überspannungsschutz auch ein Überstromschutz gewünscht, empfiehlt es sich, die Gateelektrode 11 mit einer Zuführung 26 zu versehen und diese durch das Gehäuse nach außen zu führen. Zwischen die Zuführung 26 und den Katodenanschluß K wird dann ein niederohmiger Widerstand 27 gelegt.

Bezugszeichenliste:

G Gateelektrode
K Katodenelektrode
A Anodenelektrode
1 Thyristor
2 Widerstand
3 Zenerdiode
4 Kurzschlußbrücke
5 Zenerdiode
6 Substrat
7 Mittelzone
8 Basiszone
9 Katodenzone
10 Katodenelektrode
11 Gateelektrode
13 Rand
14 Anodenzone
15 Katodenzone
16 Leiter
17, 18 Leitung
19 Nebenschlüsse
20, 21, 22, 23 Leiterbahn
24 Kurzschlußbrücke
25 Anschlußleiter
26 Zuführung
27 Widerstand

## Ansprüche

1. Integrierte Schaltungsanordnung zum Schutz von Teilnehmerleitungen gegen Überspannungen, **gekennzeichnet** durch einen feldsteuerbaren Thyristor (1) mit einer gegen den Halbleiterkörper isolierten Gateelektrode (G),
durch einen zwischen Katodenelektrode (K) und Gateelektrode (G) angeschlossenen Widerstand - (2),

durch eine zwischen Gateelektrode und Anodenelektrode angeschlossene Reihenschaltung von Zenerdioden (3),

durch jeweils zwischen Anode und Katode mindestens eines Teils der Zenerdioden angeordnete Kurzschlußbrücken (4), von denen mindestens ein Teil entsprechend einer vorgegebenen Durchbruchsspannung der Reihenschaltung unterbrochen ist,

und durch eine Durchbruchsspannung des Thyristors, die größer als die Durchbruchsspannung der Reihenschaltung sämtlicher Zenerdioden ist.

2. Integrierte Schaltungsanordnung nach Anspruch 1, **dadurch gekennzeichnet,** daß dem Widerstand (2) mindestens eine Zenerdiode (5) parallelgeschaltet ist.

3. Integrierte Schaltungsanordnung nach Anspruch 1 oder 2, **gekennzeichnet** durch die Merkmale:

a) Der Thyristor besteht aus vier im Zentrum eines Halbleiterkörpers angeordneten Zonen (6, 7, 8, 9) abwechselnden Leitungstyps,

b) die Zonen bilden eine Anodenzone (6), eine anodenseitige Basiszone (7), eine katodenseitige Basiszone (8) und eine Katodenzone (9),

c) die katodenseitige Basiszone (8) ist planar in die anodenseitige Basiszone (7) eingebettet, tritt zwischen der Katodenzone (9) und dem Rand (13) des Halbleiterkörpers an die Oberfläche und ist dort von der Gateelektrode (11) überdeckt,

d) die Katodenzonen (15) der Zenerdioden - (13) sind zwischen dem Thyristor und dem Rand - (13) des Halbleiterkörpers planar in die Mittelzone - (7) eingebettet,

e) die Katodenzonen (15) der Zenerdioden sind jeweils planar in die Anodenzonen (14) eingebettet,

f) die Zenerdioden sind als Reihe entlang des Randes des Halbleiterkörpers angeordnet,

g) die Katodenzone (15) der ersten Zenerdiode ist über eine Metallschicht mit der anodenseitigen Basiszone (7) oder der Anodenzone (6) des Thyristors verbunden,

h) die Anodenzone (14) einer Zenerdiode ist jeweils über eine Metallschicht (21) mit der Katodenzone (15) der nächsten Zenerdiode verbunden,

i) die Kurzschlußbrücke (4) besteht aus einer die Anodenzone (14) und die Katodenzone (15) ein und derselben Zenerdiode kontaktierenden Metallschicht.

4. Integrierte Schaltungsanordnung nach Anspruch 3, mit einem den Halbleiterkörper einschließenden Gehäuse, **dadurch gekennzeichnet,** daß mindestens ein Teil der Metallschichten - (21) mit einem Anschlußleiter (25) versehen ist, und daß diese Anschlußleiter durch das Gehäuse nach außen geführt sind.

5. Integrierte Schaltungsanordnung nach Anspruch 3, mit einem den Halbleiterkörper einschließenden Gehäuse, **dadurch gekennzeichnet,** daß die Gateelektrode (11) mit einem Anschlußleiter (26) versehen ist, und daß der Anschlußleiter durch das Gehäuse nach außen geführt ist.

6. Integrierte Schaltungsanordnung nach einem der Ansprüche 3 bis 5, **dadurch gekennzeichnet,** daß zwischen der Katodenzone (15) einer zwischen Gateelektrode (11) und Anodenzone (6) liegenden Zenerdiode (3) und der anodenseitigen Basiszone - (7) des Thyristors durch die Anodenzone (14) der Zenerdiode (3) hindurch eine leitende Verbindung besteht.

7. Integrierte Schaltungsanordnung nach einem der Ansprüche 3 bis 5, **dadurch gekennzeichnet,** daß die Metallschicht (21) einer der zwischen Gateelektrode (11) und Anodenzone (6) liegenden Zenerdioden (3) über eine Kurzschlußbrücke (24) direkt mit der anodenseitigen Basiszone (7) des Thyristors verbunden ist.

8. Integrierte Schaltungsanordnung nach einem der Ansprüche 1 bis 7, **dadurch gekennzeichnet,** daß die Zenerdioden (3) für eine Spannung von 6 V ausgelegt sind.

9. Integrierte Schaltungsanordnung nach einem der Ansprüche 1 bis 8, **dadurch gekennzeichnet,** daß die anodenseitige Basiszone (7) aus zwei unterschiedlich stark dotierten Schichten besteht, und daß die schwächer dotierte Schicht an die anodenseitige Basiszone (7) angrenzt.

FIG 1

FIG 2

# FIG 3

# FIG 4

# FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | ELEKTOR, Band 9, Nr. 7/8, Juli/August 1983, Seite 741, Canterbury, Kent, GB; "Emergency mains cut-out" * Insgesamt * | 1 | H 02 H 9/04 H 01 L 27/06 H 01 L 29/74 |
| Y | EP-A-0 017 980 (SIEMENS) * Zusammenfassung * | 1 | |
| A | US-A-4 271 445 (HARTMAN et al.) * Figur 2; Zusammenfassung * | 1 | |
| D,A | GB-A-2 144 267 (SGS-ATES) & DE-A-3 428 067 | | |

RECHERCHIERTE SACHGEBIETE (Int. Cl.4)

H 02 H
H 01 L

Der vorliegende Recherchenbericht wurde für alle Patentansprüche erstellt.

| Recherchenort | Abschlußdatum der Recherche | Prüfer |
|---|---|---|
| DEN HAAG | 09-02-1987 | KOLBE W.H. |

KATEGORIE DER GENANNTEN DOKUMENTE
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82